(19) Europäisches Patentamt
European Patent Office
Office européen des brevets

(11) **EP 2 220 767 B1**

(12) **EUROPÄISCHE PATENTSCHRIFT**

(45) Veröffentlichungstag und Bekanntmachung des Hinweises auf die Patenterteilung:
**04.09.2013 Patentblatt 2013/36**

(21) Anmeldenummer: **08849634.4**

(22) Anmeldetag: **15.09.2008**

(51) Int Cl.:
**H03K 17/955** (2006.01)   **G08B 13/08** (2006.01)

(86) Internationale Anmeldenummer:
**PCT/EP2008/007662**

(87) Internationale Veröffentlichungsnummer:
**WO 2009/062562 (22.05.2009 Gazette 2009/21)**

(54) **VERFAHREN UND SCHALTUNG ZUR DETEKTION EINER ANNÄHERUNG AN EINE ELEKTRODENEINRICHTUNG**

METHOD AND CIRCUIT FOR DETECTING AN APPROACH TO AN ELECTRODE DEVICE

PROCÉDÉ ET CIRCUIT DE DÉTECTION D'UN RAPPROCHEMENT PAR RAPPORT À UN SYSTÈME D'ÉLECTRODES

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **13.09.2007 DE 102007043629**

(43) Veröffentlichungstag der Anmeldung:
**25.08.2010 Patentblatt 2010/34**

(73) Patentinhaber: **Microchip Technology Germany II GmbH & Co. KG**
**82205 Gliching (DE)**

(72) Erfinder:
• **FASSHAUER, Peter**
**85579 Neubiberg (DE)**
• **SCHWAIGER, Hans**
**81377 München (DE)**

(74) Vertreter: **Grubert, Andreas et al**
**King & Spalding International LLP**
**125 Old Broad Street**
**London EC2N 1AR (GB)**

(56) Entgegenhaltungen:
**US-A- 3 826 979    US-A- 4 016 490**
**US-B1- 6 366 099**

EP 2 220 767 B1

**EP 2 220 767 B1**

**Beschreibung**

Die Erfindung richtet sich auf ein Verfahren und eine Schaltung zur Erfassung der Annäherung eines Objektes, insbesondere einer Person an eine Elektrodeneinrichtung auf Grundlage feldelektrischer Wechselwirkungseffekte gemäß dem Oberbegriff von Patentanspruch 1.

Aus US 6,366,099 B1 ist eine Schaltungseinrichtung bekannt durch welche die Kapazitätsdifferenz von zwei Kondensatorsystemen erfasst wird gemäß dem Oberbegriff der Ansprüche 1 und 5. Hierbei werden die beiden Kondensatorsysteme durch einen Rechteckgenerator und jeweils eine Vorschaltdiode gegenpolig geladen. Die Ladungsdifferenz der Kondensatorsysteme wird über eine Widerstandsmessbrücke gemessen. Der Spannungspegel der Messbrücke wird über einen Operationsverstärker geführt. An den Eingang des Operationsverstärkers und damit auch an den Mittelpunkt der Messbrücke wird über parallel angeordnete R/C Glieder das Ausgangssignal des Operationsverstärkers zurückgeführt.

Aus US 3,826,979 A ist ein als Regen-Detektor vorgesehene Streufeldsensoreinrichtung bekannt. Diese umfasst drei Elektroden. Die erste dieser Elektroden fungiert als Feldemissionselektrode und ist an einen Wechselspannungsgenerator angebunden. Die zweite Elektrode bildet eine Absorptionselektrode welche das Hauptgegenpotential zur Feldemissionselektrode bildet. Die dritte Elektrode bildet die eigentliche Sensorelektrode. Diese Sensorelektrode wird dann ausgeprägt von dem seitens der Feldemissionselektrode emittierten Feld erfasst, wenn Regentropfen auf eine mit der Sensoreinrichtung ausgestattete Windschutzscheibe treffen. Bei dieser Schaltung wird die Differenz zwischen der Spannung des Wechselspannungsgenerators und der Spannung an der Sensorelektrode erfasst und durch einen Operationsverstärker zu einem Ausgangssignal konvertiert.

Aus US 4,016,490 ist eine weitere Sensoreinrichtung bekannt, die in ihrem Aufbau der Schaltung nach US 3,826,979 A ähnlich ist, wobei die dort vorgesehene Gruppe aus drei Elektroden der Erfassung einer Fingerkuppe dient.

Aufgabe der Erfindung

Der Erfindung liegt die Aufgabe zugrunde, Lösungen zu schaffen durch welche die Annäherung eines Objektes an eine Elektrodeneinrichtung in einer gegenüber anderweitigen Störeinflüssen relativ unempfindlichen Weise bewerkstelligt werden kann.

Diese Aufgabe wird gemäß einem ersten Aspekt der vorliegenden Erfindung durch eine Schaltung mit den in Patentanspruch 1 angegebenen Merkmalen gelöst.

Durch den erfindungsgemäßen Ansatz wird es auf vorteilhafte Weise möglich, bei einer hohen Sensorempfindlichkeit einer Übersteuerung der an die Empfangselektrodeneinrichtung angebundenen Schaltung vorzubeugen.

Vorteilhafte Ausgestaltungen dieser Schaltung sind Gegenstand der Unteransprüche.

Weitere Einzelheiten und Merkmale der Erfindung ergeben sich aus der nachfolgenden Beschreibung in Verbindung mit der Zeichnung. Es zeigt:

**Fig. 1** eine Schemadarstellung zur Veranschaulichung des Grundaufbaus einer erfindungsgemäßen Sensorschaltung;

**Fig. 2** eine Grafik zur Veranschaulichung der durch den Teilstrom i2 in den Proportionalbereich verlagerten Auswertungsspannung;

**Fig. 3** eine Schemadarstellung zur Veranschaulichung eines Anwendungsbeispiels der erfindungsgemäßen Schaltung bei einer Fenstersicherung;

**Fig.4** eine Schemadarstellung zur weiteren Veranschaulichung der erfindungsgemäßen Generierung eines Ausgangssignales bei einer Näherungssensoreinrichtung, insbesondere einer Fenstersicherung.

Das erfindungsgemäße Konzept basiert auf einem Verfahren bei welchem zwischen einer Sendeelektrode (Tx) und einer Empfangselektrode (Rx) eine elektrisches Wechselfeld im Frequenzbereich von vorzugsweise 80 bis 150 kHz erzeugt wird. Taucht der leitende Gegenstand, z.B. ein Körperteil in dieses Feld zwischen den Elektroden ein, so kommt es zu einer teilweisen Absorption des Feldes über diesen Körper und damit zu einer Abschwächung eines Empfangssignales, das über einen an der Empfangselektrode angeschlossenen Verstärker gewonnen wird. Die hierbei entstehende absolute Signaländerung am Empfängerausgang ist direkt proportional zu der an der Sendeelektrode Tx anliegenden Amplitude des von einem Generator erzeugten Trägers.

Um eine möglichst große Signaländerung und damit hohe Sensorempfindlichkeit bei Annäherung zu erreichen, wird die Generatorspannung möglichst groß eingestellt. Eine Begrenzung hierfür war bisher durch eine prinzipiell eingeschränkte Aussteuerbarkeit einer auf der Empfängerseite angeschlossenen Verstärkerstufe gegeben.

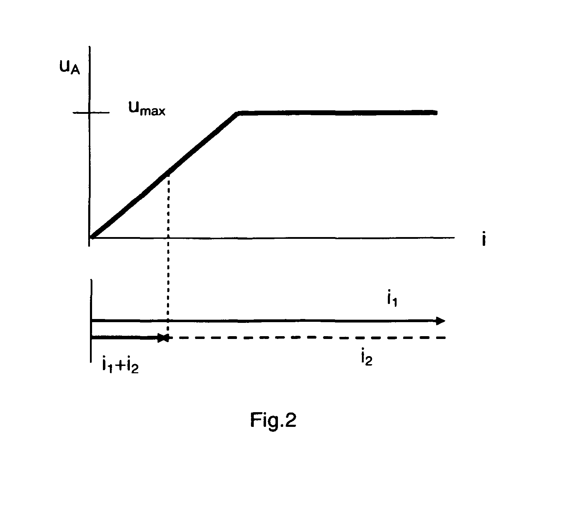

In Figur 2 ist der Verlauf einer Kennlinie dargestellt die den Zusammenhang zwischen einem Eingangsstrom und der Ausgangsspannung zeigt. Hierbei ist der Eingangsstrom proportional zur Generatorspannung .

Im Bereich relativ kleiner Eingangsströme ergibt sich ein linearer Zusammenhang, der bei Erreichen einer Maximalspannung eine Begrenzung erfährt. Nur im linearen Bereich lässt sich eine Änderung des Eingangsstromes detektieren.

Durch das erfindungsgemäße Konzept wird es möglich selbst bei einem Signalstrom bzw. einer Generatorspannung weit oberhalb des Begrenzungsbereiches die Signaländerung im linearen Bereich zu halten, wodurch eine wesentlich höhere Sensorempfindlichkeit erreicht wird.

Prinzip der erfindungsgemäßen Schaltung und des hiermit ermöglichten Kompensationsverfahrens für Feldabsorptions-Sensoren

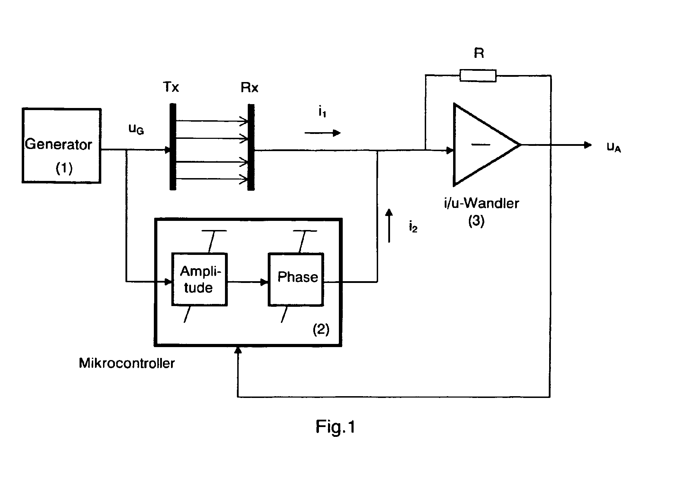

In Fig.1 ist ein Schema dargestellt, das die wesentlichen Merkmale des erfindungsgemäßen Konzeptes und auch die Funktionen des Verfahrens veranschaulicht.

Ein Generator (1) erzeugt ein Trägersignal $u_G$ im Frequenzbereich 80 kHz bis 150 kHz . Dieses Signal liegt einerseits an der Sendeelektrode Tx und zum anderen am Eingang einer Kompensationsstufe (2) an, mit der die Amplitude und Phasenlage eines Kompensationssignales eingestellt werden kann, das als Teilstrom $i_2$ mit dem von der Empfangselektrode Rx gelieferten Signalstrom $i_1$ den Eingangsstrom $i=i_1+i_2$ für einen folgenden StromSpannungswandler (3) bildet, an dessen Ausgang dann eine Spannung entsteht

$$u_A = - R ( i_1+i_2) \qquad\qquad (1)$$

Es ergeben sich weiter folgende Zusammenhänge zwischen den eingeführten Größen, bei denen lediglich die Betragswerte (Amplituden) betrachten werden. Es wird ferner vorausgesetzt, dass zwischen $i_1$ und $i_2$ außer einer Phasenverschiebung von 180° keinerlei sonstigen Phasenabweichungen zusätzlich vorhanden sind, was durch einen geeigneten Abgleich erreicht werden kann. Mit einem Absorptionskoeffizienten $\alpha$, der die relative Signaländerung durch die Feldabsorption gegenüber dem Grundzustand beschreibt, erhält man dann

$$i_1 = k_1 ( 1-\alpha) \ u_G \qquad\qquad (2)$$

$$i_2 = - k_2 u_G \qquad\qquad (3)$$

worin $k_1$ und $k_2$ Proportionalitätsfaktoren für die Amplituden sind. Damit wird Gl.1 zu

$$u_A = - u_G R [ k_1 (1-\alpha) - k_2] \qquad (4)$$

Eine maximale Kompensation ergibt sich dann für $k_1 = k_2$, womit sich dann für Gl.4 ergibt

$$u_A = u_G k_1 \alpha R \qquad\qquad (5)$$

Es sei $u_{G1}$ die für Erreichen einer maximalen Ausgangsspannung $u_{max}$ (sh.Fig.2) erforderliche Sendspannung

im unkompensierten Fall ( $k_2 = 0$). Hierfür folgt aus Gl.4

$$u_{G1} = u_{max}/ k_1(1-\alpha) R \qquad (6)$$

Für den kompensierten Fall entsprechend Gl.5 folgt dann

$$u_{G2} = u_{max} / k_1\alpha R \qquad (7)$$

Das Verhältnis der Sendespannungen in beiden Fällen repräsentiert die Erhöhung der Empfindlichkeit , da der zulässige Signalstrom $i_1$ und damit auch dessen Änderungen proportional zu $u_G$ ist, wie bereits erläutert wurde. Dies beträgt mit den Gln. (6) und (7)

$$u_{G2}/u_{G1} = (1-\alpha) / \alpha \qquad (8)$$

Für z.B. $\alpha = 0,1$ ergibt sich eine 9-fach höhere Empfindlickeit des Sensors.

Realisierung des Verfahrens

Eine zweckmäßige praktische Umsetzung des Verfahrens besteht darin, den Kompensationskanal weitgehend mittels eines Mikrocontrollers mit integrierten Analog/ Digital- und Digital/Analog Convertern zu realisieren, da hiermit die Aufgaben der Amplituden- und Phasenanpassung an das Messsignal am flexibelsten über die Software gelöst werden können. Insbesondere können hiermit relativ leicht Anpassungen an zeitvariante Systeme durchgeführt werden, wie sie z.B. bei Bewegungen der Sende - und Empfangselektroden zueinander auftreten. Hier ist es erforderlich, das Kompensationssignal im gleichen Maße zu verändern wie sich das Sensorsignal ändert. Durch Rückführung des Ausgangssignales des i/u-Wandlers zum Mikrocontroller (s.Fig.1) kann so der Nullabgleich auch automatisiert werden.

Vorteile des Verfahrens

Neben der beschriebenen Erhöhung der Sensorempfindlickeit bietet das erfindungsgemäße Verfahren auch den Vorteil, mit deutlich längeren Sensorelektroden zu arbeiten und ggf. auf eine Elektrodensegmentierung zu verzichten, was eine wesentliche Vereinfachung und Kosteneinsparung beim Produktionsprozess solcher Sensorsysteme bedeutet.

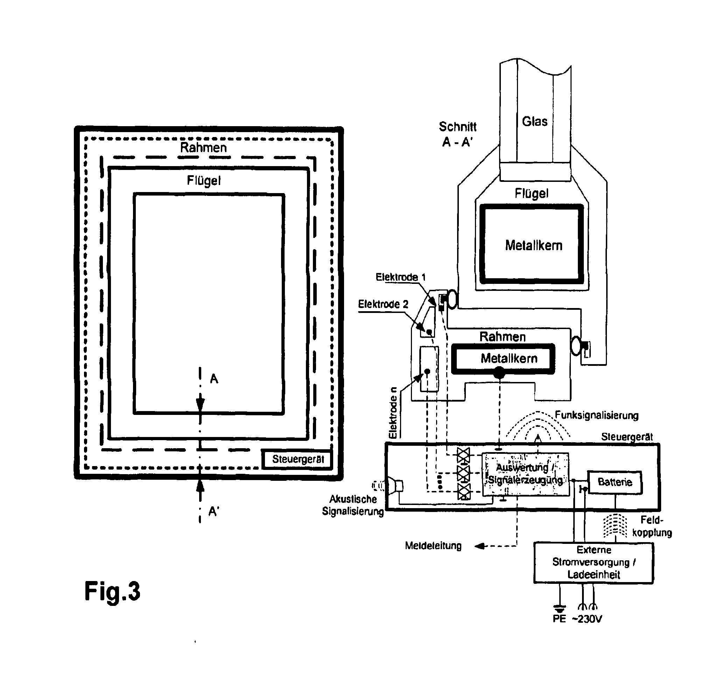

In Figur 3 ist ein Anwendungsbeispiel zur Realisierung einer beispielsweise als Einbruchssicherung verwendeten Fenstersicherung dargestellt. Die vorzugsweise in den stationären Fensterstock eingebundenen Sende und/oder Empfangelektroden können aus einem Leitungsstück bestehen oder segmentiert sein.
Es ist möglich, die Signale durch Abfrage mehrerer Elektroden (1.. n) zu generieren und die Relation der Signale untereinander neben der Alarmerkennung auch dazu zu verwenden, Umwelteinflüsse und Driften zu kompensieren.
Die Elektroden können schleifenförmig angeordnet sein und mit einem Messstrom beaufschlagt werden, der zur Erkennung von Leitungsbrüchen (Defekt, Sabotage,...) dient.
Die Elektronik kann wahlweise netzbetrieben und/oder batteriebetrieben (z.B. Netzausfall) und/oder mit Akkumulatoren betrieben werden.
Die Energiezuführung zur Ladung der Akkumulatoren und/oder dem Betrieb der Elektronik kann wahlweise über einen Feldkoppelmechanismus (E-Feld, H-Feld) erfolgen.
Ein im Rahmen typischerweise aus statischen Gründen vorhandener Metallkern kann als Massebezug für die Elektronik verwendet werden. Optional kann der Massebezug über Metallfolien hergestellt werden, die in geeigneter Weise im Rahmen integriert werden. Als Massebezug für die Elektronik kann das Erdpotential/Schutzleiterpotential dienen.

Die Elektroden und die Elektronik ist bevorzugt nur im Rahmen untergebracht (keine bewegte Leitung zum Flügel). Die Alarmmeldung kann akustisch und/oder über Funk und/oder über eine Meldeleitung erfolgen.

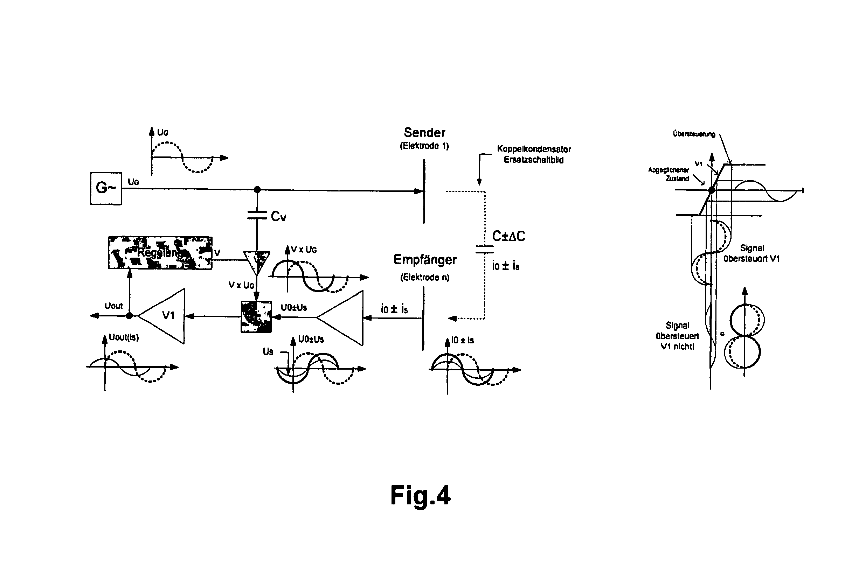

Wie aus der Schaltungsskizze nach Figur 4 ersichtlich, liegt die Generatorwechselspannung an der Sende-Elektrode 1 an. Ein kapazitiver Strom (90° voreilend) koppelt auf die Empfangselektrode n. Über einen ((-I/U)-Wandler) wird der kapazitive Strom in eine um 90° voreilende und invertierte Spannung umgesetzt. Diese Spannung wird zu einer durch Cv ebenfalls um 90° voreilende und mit einem Faktor v multiplizierte Spannung addiert. Durch Regelung von v kann im Abgleichzustand (ΔC=O) die Ausgangsspannung Uout auf ein Minimum (ideal=0) reduziert werden.

Abgeglichener Zustand:

Bei Kapazitätsänderung AC wird die Amplitude des kapazitiven Stroms verändert (is). Nach dem Addierglied (+) bleibt von der Ausgangsspannung des (-I/U)-Wandlers nur eine der Kapazitätsänderung AC proportionale Spannungsamplitude übrig. Diese kann durch den nachfolgenden Verstärker Vi - ohne diesen zu übersteuern - verstärkt werden.

## Patentansprüche

1. Schaltung zur Generierung eines hinsichtlich der Annäherung eines Objekts an einen Observationsbereich indikativen Signales, mit

    - einer Sendeelektrodeneinrichtung (Tx),
    - einer Generatorschaltung (1) zur Beaufschlagung der Sendeelektrodeneinrichtung (Tx) mit einer Wechselspannung;
    - einer Empfangselektrodeneinrichtung (Rx) die sich in, oder entlang des Observationsbereiches erstreckt,
    - einer Ausgangsschaltung (3), zur Generierung eines mit dem an der Empfangselektrodeneinrichtung (Rx) anliegenden Feld korrelierenden Ausgangssignales ($U_A$), und
    einer Kompensationsschaltung (2), zur Addition eines Kompensationsstromes (i2) zu einem von der Empfangselektrodeneinrichtung (Rx) fließenden Signalstrom (i1), wobei der Kompensationsstrom (i2) derart eingespeist wird, dass dessen Phasenverschiebung gegenüber dem Signalstrom (i1) im Bereich von 180° liegt,
    **dadurch gekennzeichnet,**
    - **dass** die Amplitude des Kompensationsstroms (i2) nach Maßgabe des Ausgangssignales ($U_A$) abgestimmt wird.

2. Schaltung nach Anspruch 1, **dadurch gekennzeichnet, dass** die Kompensationsschaltung (2) über die Generatorspannung ($U_G$) getriggert wird.

3. Schaltung nach wenigstens einem der Ansprüche 1 oder 2, **dadurch gekennzeichnet, dass** die Ausgangssschaltung (3) als I/U Wandler ausgeführt ist.

4. Schaltung nach wenigstens einem der Ansprüche 1 bis 3, **dadurch gekennzeichnet, dass** die Kompensationsschaltung (2) als Microcontroller ausgeführt ist.

5. Verfahren zur Generierung eines hinsichtlich der Annäherung eines Objekts an einen Observationsbereich indikativen Signales, bei welchem

    - eine Sendeelektrodeneinrichtung mittels einer Generatorschaltung mit einer Wechselspannung beaufschlagt wird,
    - von einer Empfangselektrodeneinrichtung die sich in, oder entlang des Observationsbereiches erstreckt, ein Signalstrom abgegriffen, und
    - mittels einer Ausgangsschaltung, ein mit dem an der Empfangselektrodeneinrichtung anliegenden Feld korrelierendes Ausgangssignal erzeugt wird,
    - wobei mittels einer Kompensationsschaltung ein Kompensationsstrom (i2) zu einem von der Empfangselektrodeneinrichtung fließenden Signalstrom addiert wird, wobei der Kompensationsstrom (i2) derart eingespeist wird, dass dessen Phasenverschiebung gegenüber dem Signalstrom (i1) im Bereich von 180° liegt
    - **dadurch gekennzeichnet, dass** die Amplitude des Kompensationsstroms nach Maßgabe des Ausgangssignales abgestimmt wird,

6. Verfahren nach Anspruch 5, **dadurch gekennzeichnet, dass** das Ausgangssignal anhand eines mit der Empfangselektrodeneinrichtung gekoppelten Wandlers generiert wird.

**Claims**

1. A circuit for generating a signal indicative for the approach of an object towards an observation area, comprising

   - a transmitting electrode device (Tx),
   - a generator circuit (1) for loading the transmitting electrode device (Tx) with an alternating voltage;
   - a receiving electrode device (Rx) extending into or along the observation area,
   - an output circuit (3) for generating an output signal ($U_A$) correlating with the field present at the receiving electrode device (Rx), and
   - a compensation circuit (2) for adding a compensation current (i2) to a signal current (i1) flowing from the receiving electrode device (Rx), wherein the compensation current (i2) is applied such that its phase shift with respect to the signal current (i1) is in the range of 180°,
   **characterized in that**,
   - the amplitude of the compensation current (i2) is adjusted as a measure of the output signal ($U_A$).

2. The circuit of claim 1, **characterized in that** die compensation circuit (2) is triggered via the generator voltage ($U_G$).

3. The circuit of at least one of claims 1 or 2, **characterized in that** the output circuit (3) is carried out as an I/U converter.

4. The circuit of at least one of claims 1 to 3, **characterized in that** the compensation circuit (2) is carried out as a microcontroller.

5. A method for generating a signal indicative for the approach of an object towards an observation area, in which

   - a transmitting electrode device is loaded with an alternating voltage by means of a generator circuit,
   - a signal current is tapped from a receiving electrode device extending into or along the observation area, and an output signal correlating with the field present at the receiving electrode device is generated by means of an output circuit,
   - wherein a compensation current (i2) is added to a signal current flowing from the receiving electrode device by means of a compensation circuit
   - wherein the compensation current (i2) is applied such that its phase shift with respect to the signal current (i1) is in the range of 180°,
   - **characterized in that** the amplitude of the compensation current is adjusted as a measure of the output signal.

6. The method of claim 5, **characterized in that** the output signal is generated by means of a converter coupled with the receiving electrode device.

**Revendications**

1. Circuit de génération d'un signal indicatif en matière de rapprochement d'un objet au niveau d'une zone d'observation, comprenant

   - un dispositif d'électrodes d'émission (Tx),
   - un circuit de générateur (1) pour alimenter le dispositif d'électrodes d'émission (Tx) avec une tension alternative ;
   - un dispositif d'électrodes de réception (Rx) qui s'étend dans, ou le long de, la zone d'observation,
   - un circuit de sortie (3) pour générer un signal de sortie ($U_A$) qui est en corrélation avec le champ contigu au dispositif d'électrodes de réception (Rx), et
   un circuit de compensation (2) pour ajouter un courant de compensation (i2) à un courant de signal (i1) s'écoulant du dispositif d'électrodes de réception (Rx), le courant de compensation (i2) étant alimenté de sorte que son déphasage par rapport au courant de signal (i1) se situe dans la plage de 180 °,
   **caractérisé en ce que**
   - l'amplitude du courant de compensation (i2) est déterminée conformément au signal de sortie ($U_A$).

**2.** Circuit selon la revendication 1, **caractérisé en ce que** le circuit de compensation (2) est déclenché par le biais de la tension de générateur ($U_G$).

**3.** Circuit selon au moins l'une des revendications 1 ou 2, **caractérisé en ce que** le circuit de sortie (3) est réalisé en tant que convertisseur I/U.

**4.** Circuit selon au moins l'une des revendications 1 à 3, **caractérisé en ce que** le circuit de compensation (2) est réalisé en tant que microcontrôleur.

**5.** Procédé de génération d'un signal indicatif en matière de rapprochement d'un objet au niveau d'une zone d'observation, dans lequel

- un dispositif d'électrodes d'émission est alimenté en tension alternative au moyen d'un circuit de générateur,
- un courant de signal est prélevé par un dispositif d'électrodes de réception qui s'étend dans ou le long d'une zone d'observation, et
- un signal de sortie qui est en corrélation avec le champ contigu au dispositif d'électrodes de réception est produit au moyen d'un circuit de sortie,
- un courant de compensation (i2) étant ajouté, au moyen d'un circuit de compensation, à un courant de signal s'écoulant du dispositif d'électrodes de réception,
le courant de compensation (i2) étant alimenté de sorte que son déphasage par rapport au courant de signal (i1) se situe dans la plage de 180 °,
- **caractérisé en ce que** l'amplitude du courant de compensation est déterminée conformément au signal de sortie.

**6.** Procédé selon la revendication 5, **caractérisé en ce que** le signal de sortie est généré à l'aide d'un convertisseur couplé au dispositif d'électrodes de réception.

R

Tx    Rx

Generator
(1)

$u_G$

$i_1$

$u_A$

i/u-Wandler
(3)

$i_2$

Amplitude

Phase

(2)

Mikrocontroller

Fig.1

Fig.2

**Fig.3**

Fig.4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6366099 B1
- US 3826979 A
- US 4016490 A